# EUROPEAN PATENT APPLICATION

(11) **EP 4 604 393 A1**
(43) Date of publication of application: **20.08.2025**
(21) Application number: 23911702.1
(22) Date of filing: 12.12.2023
(51) Int. Cl.: H03F 1/02

(54) **TRACKER CIRCUIT, COMMUNICATION DEVICE, AND TRACKING METHOD**

(30) Priority: 28.12.2022 US 202263477420 P
(71) Applicant: Murata Manufacturing Co., Ltd., Nagaokakyo-shi, Kyoto 617-8555 (JP)
(72) Inventor: HOVERSTEN, John, Cambridge, Massachusetts 02142 (US); PERREAULT, David, Cambridge, Massachusetts 02142 (US); TKACHENKO, Yevgeniy, Cambridge, Massachusetts 02142 (US); KOGURE, Takeshi, Nagaokakyo-shi, Kyoto 617-8555 (JP); KATO, Muneharu, Nagaokakyo-shi, Kyoto 617-8555 (JP); MATSUI, Toshiki, Nagaokakyo-shi, Kyoto 617-8555 (JP)
(74) Representative: Zimmermann, Tankred Klaus
(86) International application number: PCT/JP2023/044498
(87) International publication number: WO 2024/142921

(57) **Abstract**

A tracker circuit (1) includes a switched-capacitor circuit (20) configured to generate a plurality of discrete voltages and a supply modulator (30) configured to selectively output at least one of the plurality of discrete voltages to a power amplifier (2). Based on a difference between a first input voltage and a second input voltage that is variable and that is lower than the first input voltage, the switched-capacitor circuit (20) is configured to generate the plurality of discrete voltages.

## Description

### Technical Field

The present invention relates to a tracker circuit, a communication device, and a tracking method.

### Background Art

In Patent Document 1, applying a digital envelope tracking (ET) mode of supplying a plurality of discrete voltages to a power amplifier leads to improvement in power efficiency.

### Citation List

### Patent Document

Patent Document 1 United States Patent No. 8829993

### Summary of Invention

### Technical Problem

However, further improvement in power efficiency is desired in the digital ET mode.

Accordingly, the present invention provides a tracker circuit, a communication device, and a tracking method that are enabled to improve power efficiency.

### Solution to Problem

A tracker circuit according to an aspect of the present invention includes: a switched-capacitor circuit configured to generate a plurality of discrete voltages; and a supply modulator configured to selectively output at least one of the plurality of discrete voltages to a power amplifier. The switched-capacitor circuit is configured to generate the plurality of discrete voltages, based on a difference between a first input voltage and a second input voltage that is variable and that is lower than the first input voltage.

A tracker circuit according to an aspect of the present invention includes: a switched-capacitor circuit that includes a first input terminal and a second input terminal and that is configured to generate a plurality of discrete voltages, the first input terminal receiving a first input voltage, the second input terminal receiving a second input voltage that is variable and that is lower than the first input voltage; a supply modulator configured to selectively output at least one of the plurality of discrete voltages to a power amplifier; a first capacitor connected between the first input terminal and ground; and a second capacitor connected between the second input terminal and ground.

A tracking method according to an aspect of the present invention includes: receiving a first input voltage and a second input voltage lower than the first input voltage; based on a first difference between the first input voltage and the second input voltage, generating a plurality of first discrete voltages; selectively outputting at least one of the plurality of first discrete voltages to a power amplifier; receiving a third input voltage and a fourth input voltage that is lower than the third input voltage, the fourth input voltage being different from the second input voltage; based on a second difference between the third input voltage and the fourth input voltage, generating a plurality of second discrete voltages; and selectively outputting at least one of the plurality of second discrete voltages to the power amplifier.

### Advantageous Effects of Invention

With tracker circuit and the like according to an aspect of the present invention, power efficiency may be improved.

### Brief Description of Drawings

[Fig. 1A] Fig. 1A is a graph illustrating an example of power supply voltage changes in an APT mode.
[Fig. 1B] Fig. 1B is a graph illustrating an example of power supply voltage changes in an analog ET mode.
[Fig. 1C] Fig. 1C is a graph illustrating an example of power supply voltage changes in a digital ET mode.
[Fig. 2] Fig. 2 is a circuit configuration diagram of a communication device according to Embodiment 1.
[Fig. 3] Fig. 3 is a circuit configuration diagram of a tracker circuit and a pre-regulator circuit according to Embodiment 1.
[Fig. 4] Fig. 4 is a flowchart illustrating a tracking method according to Embodiment 1.
[Fig. 5A] Fig. 5A is a graph illustrating a radio frequency signal modulated by QPSK and a plurality of discrete voltages.
[Fig. 5B] Fig. 5B is a graph illustrating a relationship between the output power of a power amplifier that amplifies a radio frequency signal modulated by QPSK and an occurrence frequency.
[Fig. 5C] Fig. 5C is a graph illustrating a relationship between the output power of the power amplifier that amplifies a radio frequency signal modulated by QPSK and power efficiency.
[Fig. 6A] Fig. 6A is a graph illustrating a radio frequency signal modulated by 256QAM and a plurality of discrete voltages.
[Fig. 6B] Fig. 6B is a graph illustrating a relationship between the output power of a power amplifier that amplifies a radio frequency signal modulated by 256QAM and an occurrence frequency.
[Fig. 6C] Fig. 6C is a graph illustrating a relationship between the output power of the power amplifier that amplifies a radio frequency signal modulated by 256QAM and power efficiency.
[Fig. 7] Fig. 7 is a circuit configuration diagram of a tracker circuit according to a modification of Embodiment 1.
[Fig. 8] Fig. 8 is a communication device according to Embodiment 2.
[Fig. 9] Fig. 9 is a circuit configuration diagram of a tracker circuit and pre-regulator circuits according to Embodiment 2.
[Fig. 10] Fig. 10 is a circuit configuration diagram of a communication device according to Embodiment 3.
[Fig. 11] Fig. 11 is a circuit configuration diagram of a tracker circuit and a pre-regulator circuit according to Embodiment 3.

### Description of Embodiments

Hereinafter, embodiments of the present invention will be described in detail by using the drawings. The embodiments described below each illustrate a general or specific example. The numerical values, shapes, materials, components, the disposition and connection form of the components, and the like described in the following embodiments are examples and are not intended to limit the present invention.

The drawings are schematic diagrams having undergone emphasis, omission, or ratio adjustment performed as appropriate to illustrate the present invention. The illustration therein is not necessarily strict and is different from actual shapes, positional relationships, and ratios on occasions. In the drawings, components that are substantially the same are denoted by the same reference numerals, and a repeated description thereof is omitted or simplified in some cases.

In the circuit configurations of the present invention, the term "connected" includes not only a direct connection using a connection terminal and/or a wiring conductor but also an electrical connection via another circuit element. The phrase "directly connected" may be understood as directly connected using a connection terminal and/or a wiring conductor without interposing another circuit element. The phrase "C is connected between A and B" may be understood as one end of C is connected to A and the other end of C is connected to B. The phrase "a path between A and B" may be understood as a path composed of a conductor that electrically connects A to B.

In the circuit configurations of the present invention, the term "terminal" may be understood as a point at which a conductor in an element terminates. In a case where the impedance of a conductor between elements is sufficiently low, a terminal is interpreted as not only a single point but also any point on the conductor between the elements or the entire conductor.

In addition, terms indicating relationships between elements, such as "parallel" and "perpendicular", terms indicating the shapes of elements, such as "rectangular", and numerical ranges do not represent only strict meanings, but include substantially equivalent ranges, for example, an error of about several percent.

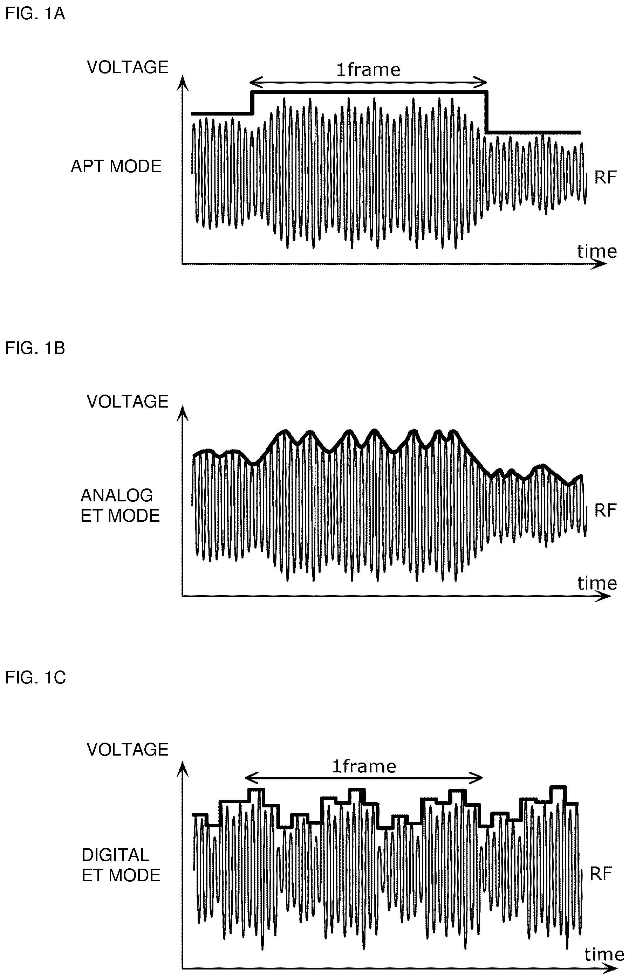

A description will be given of tracking modes in which a power amplifier is supplied with a power supply voltage dynamically regulated based on a radio frequency signal over time, which are techniques for amplifying the radio frequency signal with high efficiency. A tracking mode is a mode of dynamically regulating the power supply voltage to be applied to a power amplifier. Among several types of tracking modes, a description will herein be given of an average power tracking (APT) mode, an analog ET mode, and a digital ET mode with reference to Fig. 1A to Fig. 1C. In Fig. 1A to Fig. 1C, the horizontal axis represents time, and the vertical axis represents voltage. A thick solid line represents a power supply voltage to be supplied to a power amplifier, and a thin solid line (waveform) represents a modulated signal.

Fig. 1A is a graph illustrating an example of power supply voltage changes in the APT mode. In the APT mode, the power supply voltage is varied to a plurality of discrete voltage levels in units of one frame based on average power. As the result, a power supply voltage signal forms a rectangular wave.

A frame may be understood as a unit of elements of a radio frequency signal (modulated signal). For example, in 5th Generation New Radio (5G NR) and Long Term Evolution (LTE), a frame includes ten subframes, each subframe includes a plurality of slots, and each slot is composed of a plurality of symbols. The subframe has a length of 1 ms, and the frame has a length of 10 ms.

A mode of varying a voltage level in units of one frame or in larger units based on average power is referred to as an APT mode and is distinguished from a mode of varying a voltage level in units smaller than one frame (for example, in units of subframes, slots, or symbols). For example, a mode of varying a voltage level in units of symbols is referred to as a symbol power tracking (SPT) mode and is distinguished from the APT mode.

Fig. 1B is a graph illustrating an example of power supply voltage changes in the analog ET mode. In the analog ET mode, the power supply voltage is continuously varied based on an envelope signal, and thereby the envelope of a modulated signal is tracked.

The envelope signal is a signal indicating the envelope of a modulated signal. An envelope value is represented by, for example, the square root of (I² + Q²). Note that (I, Q) represents a constellation point herein. The constellation point is a point representing, on a constellation diagram, a signal modulated by digital modulation. A point (I, Q) is decided, for example, by a baseband integrated circuit (BBIC), for example, based on sending information.

Fig. 1C is a graph illustrating an example of power supply voltage changes in the digital ET mode. In the digital ET mode, the power supply voltage is varied to a plurality of discrete voltage levels within one frame based on an envelope signal, and thereby the envelope of a modulated signal is tracked. As the result, the power supply voltage signal forms a rectangular wave.

### (Embodiment 1)

Hereinafter, Embodiment 1 will be described.

### [1.1 Circuit Configuration of Communication Device 7]

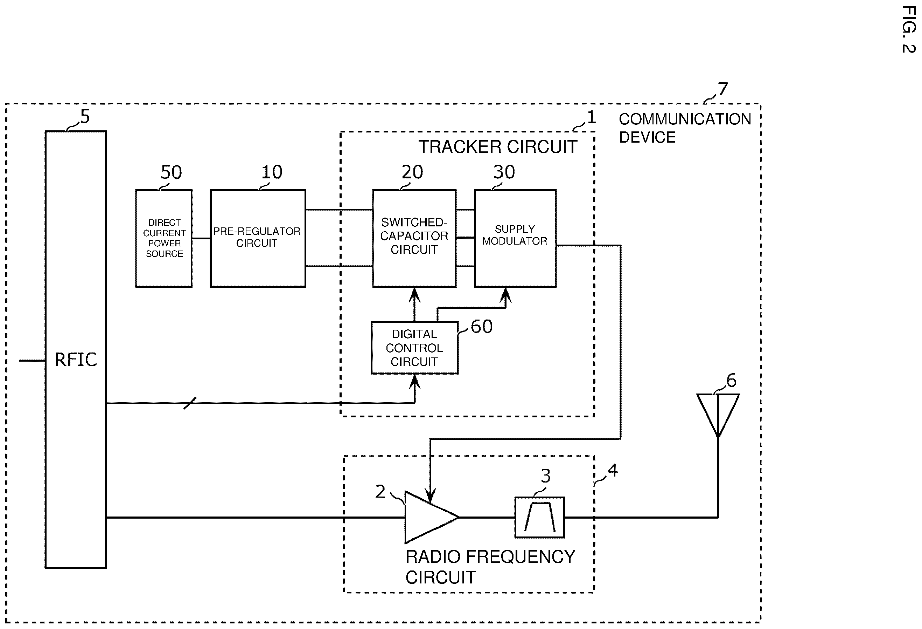

First, a communication device 7 according to this embodiment will be described with reference to Fig. 2. Fig. 2 is a circuit configuration diagram of the communication device 7 according to this embodiment.

Fig. 2 illustrates an exemplary circuit configuration, and the communication device 7 may be implemented by using any of a wide variety of circuit implementation and circuit techniques. Accordingly, the description of the communication device 7 provided below should not be construed in a limiting manner.

The communication device 7 corresponds to a user terminal (user equipment (UE)) in a cellular network and is typically a mobile phone, a smartphone, a tablet computer, a wearable device, or the like. The communication device 7 may be an Internet of Things (IoT) sensor device, a medical/health-care device, a vehicle, an unmanned aerial vehicle (UAV) (a so-called drone), or an automated guided vehicle (AGV). The communication device 7 may function as a base station (BS) in a cellular network.

As illustrated in Fig. 2, the communication device 7 includes a tracker circuit 1, a radio frequency circuit 4, a radio frequency integrated circuit (RFIC) 5, an antenna 6, a pre-regulator circuit 10, and a direct current power source 50.

The tracker circuit 1 is capable of supplying a plurality of discrete voltages to a power amplifier 2 in the digital ET mode. As illustrated in Fig. 2, the tracker circuit 1 includes a switched-capacitor circuit 20, a supply modulator 30, and a digital control circuit 60.

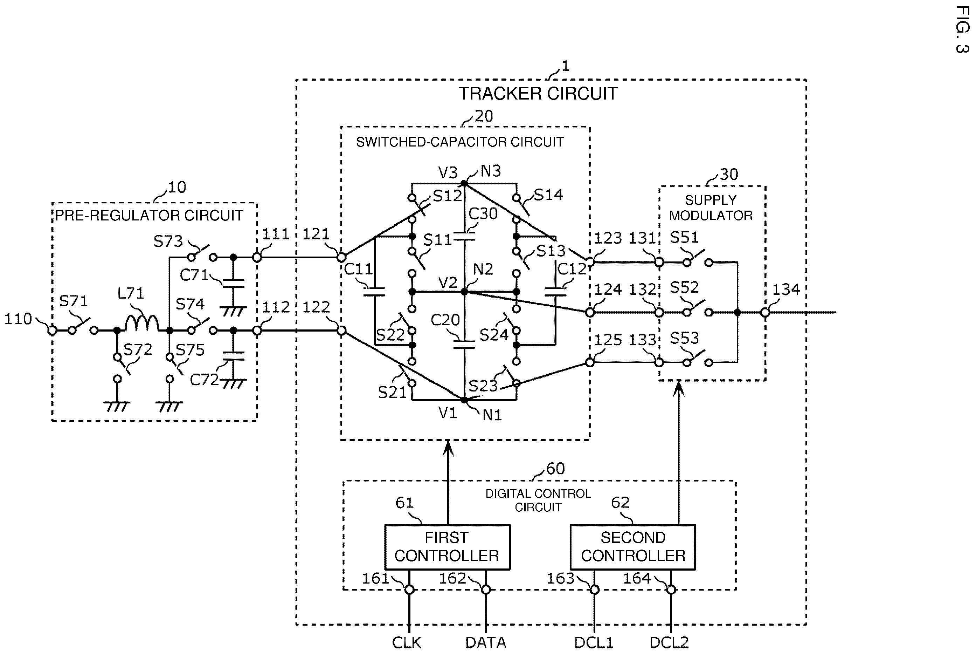

The switched-capacitor circuit 20 is a differential switched-capacitor circuit and is also referred to as a differential switched-capacitor voltage balancer on occasions. The switched-capacitor circuit 20 is capable of generating a plurality of discrete voltages including a first output voltage, a second output voltage, and a third output voltage, based on a difference between a first input voltage and a second input voltage received from the pre-regulator circuit 10. Specifically, the switched-capacitor circuit 20 is capable of generating the third output voltage to cause each of a difference between the first output voltage and the third output voltage and a difference between the second output voltage and the third output voltage to increase in response to an increase in the difference between the first input voltage and the second input voltage. It is thus possible to control the step widths of the plurality of discrete voltages by using the difference between the first input voltage and the second input voltage. In this case, the first output voltage is based on the first input voltage and is equal to the first input voltage in this embodiment. The second output voltage is based on the second input voltage and is equal to the second input voltage in this embodiment. The third output voltage is based on the difference between the first input voltage and the second input voltage and is lower than the first output voltage (first input voltage) and higher than the second output voltage (second input voltage) in this embodiment. The circuit configuration of the switched-capacitor circuit 20 will be described later by using Fig. 3.

The supply modulator 30 is capable of selectively outputting, to the power amplifier 2, at least one of the plurality of discrete voltages generated by the switched-capacitor circuit 20. The supply modulator 30 is thus capable of selecting at least one voltage from among the plurality of discrete voltages and outputting the selected voltage to the power amplifier **2.** The circuit configuration of the supply modulator 30 will be described later by using Fig. 3.

The digital control circuit 60 is capable of controlling the switched-capacitor circuit 20 and the supply modulator 30 based on digital control signals from the RFIC 5. Specifically, the digital control circuit 60 is capable of generating and outputting a control signal for controlling a switch included in the switched-capacitor circuit 20 and a control signal for controlling a switch included in the supply modulator 30. The circuit configuration of the digital control circuit 60 will be described later by using Fig. 3. The digital control circuit 60 does not necessarily have to be included in the tracker circuit 1.

The pre-regulator circuit 10 is an example of a converter circuit and is also referred to as a magnetic regulator or a direct current (DC)/DC converter on occasions. In this embodiment, the pre-regulator circuit 10 is a one-input two-output buck-boost converter and is capable of converting a power supply voltage supplied from the direct current power source 50 into two variable voltages independent of each other (the first input voltage and the second input voltage of the switched-capacitor circuit 20). The pre-regulator circuit 10 is capable of changing the first input voltage and the second input voltage of the switched-capacitor circuit 20 based on, for example, a control signal from the RFIC 5. Specifically, the pre-regulator circuit 10 is capable of switching the difference between the first input voltage and the second input voltage in accordance with, for example, a modulation scheme for a radio frequency signal amplified by the power amplifier 2. More specifically, the pre-regulator circuit 10 may increase the difference between the first input voltage and the second input voltage as the bit rate of the modulation scheme increases. Such switching of the difference between the first input voltage and the second input voltage may be performed at the time of switching of a frame of the radio frequency signal. The circuit configuration of the pre-regulator circuit 10 will be described later by using Fig. 3.

The modulation scheme for the radio frequency signal enables constellation points of the radio frequency signal to be identified by measurement. The number of separable constellation points increases as the bit rate of the modulation scheme increases.

A condition for switching the difference between the first input voltage and the second input voltage is not limited to the modulation scheme. For example, the difference between the first input voltage and the second input voltage may be switched in accordance with a power class or the like.

The direct current power source 50 is capable of supplying a power supply voltage to the pre-regulator circuit 10. The direct current power source 50 may be, but is not limited to, a rechargeable battery, for example.

The radio frequency circuit 4 is capable of transmitting a radio frequency signal between the RFIC 5 and the antenna 6. As illustrated in Fig. 2, the radio frequency circuit 4 includes the power amplifier 2 and a filter 3.

The power amplifier 2 is connected between the RFIC 5 and the filter 3. The power amplifier 2 is further connected to the tracker circuit 1. The power amplifier 2 is capable of amplifying a radio frequency signal received from the RFIC 5, by using a plurality of discrete voltages received from the tracker circuit 1.

The filter 3 is connected between the power amplifier 2 and the antenna 6. The filter 3 is a band pass filter having a pass band including a predetermined band. The filter 3 does not necessarily have to be included in the radio frequency circuit 4.

The predetermined band is a frequency band for a communication system constructed by using radio access technology (RAT) and is predefined by standardizing bodies (such as 3rd Generation Partnership Project (3GPP, registered trademark) and Institute of Electrical and Electronics Engineers (IEEE)). As examples of the communication system, a 5G NR system, an LTE system, a Wireless Local Area Network (WLAN) system, and the like can be cited.

The antenna 6 sends a radio frequency signal received from the radio frequency circuit 4. The antenna 6 does not necessarily have to be included in the communication device 7.

The circuit configuration of the communication device 7 illustrated in Fig. 2 is illustrative and is not restrictive. For example, the communication device 7 may include a baseband signal processing circuit that performs signal processing by using an intermediate frequency band lower than the frequency of a radio frequency signal.

### [1.2 Circuit Configuration of Tracker Circuit 1]

The circuit configuration of the tracker circuit 1 will then be described with reference to Fig. 3. Fig. 3 is a circuit configuration diagram of the tracker circuit 1 and the pre-regulator circuit 10 according to this embodiment.

Fig. 3 illustrates an exemplary circuit configuration, and the tracker circuit 1 and the pre-regulator circuit 10 may be implemented by using any of a wide variety of circuit implementation and circuit techniques. Accordingly, the description of the individual circuits provided below should not be construed in a limiting manner.

The tracker circuit 1 includes the switched-capacitor circuit 20, the supply modulator 30, and the digital control circuit 60, as described above. The tracker circuit 1 may include a filter circuit (not illustrated) between the supply modulator 30 and the power amplifier 2.

Hereinafter, the circuit configurations of the switched-capacitor circuit 20, the supply modulator 30, and the digital control circuit 60 will be described in order.

### [1.2.1 Circuit Configuration of Switched-Capacitor Circuit 20]

First, the circuit configuration of the switched-capacitor circuit 20 will be described with reference to Fig. 3. The switched-capacitor circuit 20 includes capacitors C11, C12, C20, and C30, switches S11 to S14 and S21 to S24, input terminals 121 and 122, and output terminals 123 to 125. Energy and electric charges are input from the pre-regulator circuit 10 to nodes N1 and N3 via the input terminals 121 and 122 and output from the nodes N1 to N3 to the supply modulator 30 via the output terminals 123 to 125.

The input terminal 121 is an example of a first input terminal and is a terminal for receiving a first input voltage (V3) from the pre-regulator circuit 10. The input terminal 121 is connected to the pre-regulator circuit 10 outside the switched-capacitor circuit 20 and is connected to the node N3 inside the switched-capacitor circuit 20.

The input terminal 122 is an example of a second input terminal and is a terminal for receiving a second input voltage (V1) from the pre-regulator circuit 10. The input terminal 122 is connected to the pre-regulator circuit 10 outside the switched-capacitor circuit 20 and is connected to the node N1 inside the switched-capacitor circuit 20.

The output terminal 123 is a terminal for supplying a first output voltage (V3) to the supply modulator 30. The output terminal 123 is connected to the supply modulator 30 outside the switched-capacitor circuit 20 and is connected to the node N3 inside the switched-capacitor circuit 20. The output terminal 123 may be integrated with the input terminal 121.

The output terminal 124 is a terminal for supplying a third output voltage (V2) to the supply modulator 30. The output terminal 124 is connected to the supply modulator 30 outside the switched-capacitor circuit 20 and is connected to the node N2 inside the switched-capacitor circuit 20.

The output terminal 125 is a terminal for supplying a second output voltage (V1) to the supply modulator 30. The output terminal 125 is connected to the supply modulator 30 outside the switched-capacitor circuit 20 and is connected to the node N1 inside the switched-capacitor circuit 20. The output terminal 125 may be integrated with the input terminal 122.

The capacitors C11 and C12 each function as a flying capacitor (also referred to as a transfer capacitor). Specifically, the capacitors C11 and C12 are each used to raise and/or lower the first input voltage and the second input voltage that are supplied from the pre-regulator circuit 10. More specifically, the capacitors C11 and C12 cause electric charges to move between the capacitors C11 and C12 and the nodes N1 to N3 so that voltages V1 to V3 satisfying (V3 - V2):(V2 - V1) = 1:1 and V3 > V2 > V1 are maintained at the three nodes N1 to N3.

The first output voltage (V3) is based on the first input voltage and is equal to the first input voltage (V3) in this embodiment. The first output voltage is higher than the second output voltage and the third output voltage.

The second output voltage (V1) is based on the second input voltage and is equal to the second input voltage (V1) in this embodiment. The second output voltage is lower than the first output voltage and the third output voltage.

The third output voltage (V2) is based on the difference between the first input voltage (V3) and the second input voltage (V1) and is lower than the first output voltage and higher than the second output voltage in this embodiment.

The capacitor C11 has two electrodes. One of the two electrodes of the capacitor C11 is connected to one end of the switch S11 and one end of the switch S12. The other of the two electrodes of the capacitor C11 is connected to one end of the switch S21 and one end of the switch S22.

The capacitor C12 has two electrodes. One of the two electrodes of the capacitor C12 is connected to one end of the switch S13 and one end of the switch S14. The other of the two electrodes of the capacitor C12 is connected to one end of the switch S23 and one end of the switch S24.

Repeating a first phase and a second phase enables charging and discharging to be performed complementally on the capacitors C11 and C12.

Specifically, in the first phase, the switches S12, S13, S22, and S23 are turned ON. Accordingly, the one of the two electrodes of the capacitor C11 is connected to the node N3, the other of the two electrodes of the capacitor C11 and the one of the two electrodes of the capacitor C12 are connected to the node N2, and the other of the two electrodes of the capacitor C12 is connected to the node N1.

In contrast, in the second phase, the switches S11, S14, S21, and S24 are turned ON. Accordingly, the one of the two electrodes of the capacitor C12 is connected to the node N3, the other of the two electrodes of the capacitor C12 and the one of the two electrodes of the capacitor C11 are connected to the node N2, and the other of the two electrodes of the capacitor C11 is connected to the node N1.

Repeating the first phase and the second phase as described above enables, for example, when one of the capacitors C11 and C12 is charged through the node N1, the other of the capacitors C11 and C12 to be discharged to the capacitor C20. Charging and discharging may thus be performed complementally on the capacitors C11 and C12.

The capacitors C20 and C30 each function as a smoothing capacitor. Specifically, the capacitors C20 and C30 are used to hold and smooth the first to third output voltages (V3, V1, and V2) at the nodes N1 to N3.

The capacitor C20 is connected between the nodes N2 and N1. Specifically, one of the two electrodes of the capacitor C20 is connected to the node N2. In contrast, the other of the two electrodes of the capacitor C20 is connected to the node N1.

The capacitor C30 is connected between the nodes N3 and N2. Specifically, one of the two electrodes of the capacitor C30 is connected to the node N3. In contrast, the other of the two electrodes of the capacitor C30 is connected to the node N2.

The switch S11 is connected between the one of the two electrodes of the capacitor C11 and the node N2. Specifically, the one end of the switch S11 is connected to the one of the two electrodes of the capacitor C11. In contrast, the other end of the switch S11 is connected to the node N2.

The switch S12 is connected between the one of the two electrodes of the capacitor C11 and the node N3. Specifically, the one end of the switch S12 is connected to the one of the two electrodes of the capacitor C11. In contrast, the other end of the switch S12 is connected to the node N3.

The switch S21 is connected between the other of the two electrodes of the capacitor C11 and the node N1. Specifically, the one end of the switch S21 is connected to the other of the two electrodes of the capacitor C11. In contrast, the other end of the switch S21 is connected to the node N1.

The switch S22 is connected between the other of the two electrodes of the capacitor C11 and the node N2. Specifically, the one end of the switch S22 is connected to the other of the two electrodes of the capacitor C11**.** In contrast, the other end of the switch S22 is connected to the node N2.

The switch S13 is connected between the one of the two electrodes of the capacitor C12 and the node N2. Specifically, the one end of the switch S13 is connected to the one of the two electrodes of the capacitor C12. In contrast, the other end of the switch S13 is connected to the node N2**.** The other end of the switch S13 is thus connected to the other end of the switch S11 and the other end of the switch S22.

The switch S14 is connected between the one of the two electrodes of the capacitor C12 and the node N3. Specifically, the one end of the switch S14 is connected to the one of the two electrodes of the capacitor C12. In contrast, the other end of the switch S14 is connected to the node N3. The other end of the switch S14 is thus connected to the other end of the switch S12.

The switch S23 is connected between the other of the two electrodes of the capacitor C12 and the node N1. Specifically, the one end of the switch S23 is connected to the other of the two electrodes of the capacitor C12. In contrast, the other end of the switch S23 is connected to the node N1. The other end of the switch S23 is thus connected to the other end of the switch S21.

The switch S24 is connected between the other of the two electrodes of the capacitor C12 and the node N2. Specifically, the one end of the switch S24 is connected to the other of the two electrodes of the capacitor C12. In contrast, the other end of the switch S24 is connected to the node N2. The other end of the switch S24 is thus connected to the other end of the switch S11, the other end of the switch S22, and the other end of the switch S13.

A first set of switches including the switches S12, S13, S22, and S23 and a second set of switches including the switches S11, S14, S21, and S24 are turned ON and OFF complementally based on a control signal from the digital control circuit 60. Specifically, in the first phase, the switches in the first set are turned ON whereas the switches in the second set are turned OFF. Conversely, in the second phase, the switches in the first set are turned OFF whereas the switches in the second set are turned ON.

For example, in one of the first phase and the second phase, charging from the capacitor C11 to the capacitors C20 and C30 is performed, and in the other of the first phase and the second phase, charging from the capacitor C12 to the capacitors C20 and C30 is performed. The capacitors C20 and C30 are thus constantly charged by the capacitor C11 or the capacitor C12. Accordingly, even if current flows rapidly from the nodes N1 to N3 to the supply modulator 30, the nodes N1 to N3 are rapidly replenished with electric charges, and potential variations at the nodes N1 to N3 may be prevented.

The operations as described above enable the switched-capacitor circuit 20 to maintain substantially equal voltages at both ends of each of the capacitors C20 and C30. Specifically, the voltages V1 to V3 (voltages with respect to a ground potential) satisfying (V3 - V2):(V2 - V1) = 1:1 are maintained at the four nodes labeled V1 to V3. The voltages V1 to V3 correspond to a plurality of discrete voltages suppliable to the supply modulator 30 by the switched-capacitor circuit 20.

The relation (V3 - V2):(V2 - V1) is not limited to 1:1 and may be designed to be any ratio (such as 2:1, 3:1, 3:2, 1:2, or 2:3).

The configuration of the switched-capacitor circuit 20 illustrated in Fig. 3 is illustrative and is not restrictive. For example, the switched-capacitor circuit 20 is configured to be able to supply voltages of three discrete voltage levels but may be configured to be able to supply voltages of any number of discrete voltage levels as long as the number is greater than or equal to four.

### [1.2.2 Circuit Configuration of Supply Modulator 30]

The circuit configuration of the supply modulator 30 will then be described with reference to Fig. 3. The supply modulator 30 includes input terminals 131 to 133, switches S51 to S53, and an output terminal 134.

The input terminals 131 to 133 are terminals for receiving the first to third output voltages of the switched-capacitor circuit 20. The input terminals 131 to 133 are respectively connected to the output terminals 123 to 125 of the switched-capacitor circuit 20 outside the supply modulator 30 and are respectively connected to the switches S51 to S53 inside the supply modulator 30.

The output terminal 134 is a terminal for selectively supplying at least one of a plurality of discrete voltages to the power amplifier 2. The output terminal 134 is connected to the power amplifier 2 outside the supply modulator 30 and is connected to the switches S51 to S53 inside the supply modulator 30.

The switch S51 is connected between the input terminal 131 and the output terminal 134. Specifically, the switch S51 includes a terminal connected to the input terminal 131 and a terminal connected to the output terminal 134. In this connection configuration, ON/OFF switching of the switch S51 by a control signal from the digital control circuit 60 enables switching between connection and disconnection between the input terminal 131 and the output terminal 134.

The switch S52 is connected between the input terminal 132 and the output terminal 134. Specifically, the switch S52 includes a terminal connected to the input terminal 132 and a terminal connected to the output terminal 134. In this connection configuration, ON/OFF switching of the switch S52 by a control signal from the digital control circuit 60 enables switching between connection and disconnection between the input terminal 132 and the output terminal 134.

The switch S53 is connected between the input terminal 133 and the output terminal 134. Specifically, the switch S53 includes a terminal connected to the input terminal 133 and a terminal connected to the output terminal 134. In this connection configuration, ON/OFF switching of the switch S53 by a control signal from the digital control circuit 60 enables switching between connection and disconnection between the input terminal 133 and the output terminal 134.

In this embodiment, these switches S51 to S53 are controlled to be exclusively turned ON. That is, only any one of the switches S51 to S53 is turned ON, and the others are turned OFF. The supply modulator 30 is thereby able to output one voltage selected from among the first to third output voltages of the switched-capacitor circuit 20 to the power amplifier 2.

The configuration of the supply modulator 30 illustrated in Fig. 3 is illustrative and is not restrictive. In particular, the switches S51 to S53 may have any configuration and may be controlled in any manner as long as at least one of the three input terminals 131 to 133 are allowed be selectively connected to the output terminal 134. For example, two of the switches S51 to S53 may be turned ON, and the other one of the switches S51 to S53 may be turned OFF.

In a case where four or more discrete voltages are supplied from the switched-capacitor circuit 20, the supply modulator 30 may further include one or more switches in addition to the switches S51 to S53.

### [1.2.3 Circuit Configuration of Digital Control Circuit 60]

The circuit configuration of the digital control circuit 60 will then be described with reference to Fig. 3. The digital control circuit 60 includes a first controller 61, a second controller 62, and control terminals 161 to 164.

The first controller 61 is capable of processing source-synchronous digital control signals received from the RFIC 5 via the control terminals 161 and 162 and thereby generating a control signal for controlling the switched-capacitor circuit 20. Turning ON/OFF of the switches S11 to S14 and S21 to S24 included in the switched-capacitor circuit 20 is controlled by the control signal from the first controller 61.

The digital control signals processed by the first controller 61 are not limited to source-synchronous digital control signals. For example, the first controller 61 may process clock-embedded digital control signals. The first controller 61 may generate a control signal for controlling the supply modulator 30.

Although one set of a clock signal and a data signal is used in this embodiment, the present invention is not limited thereto. For example, a plurality of sets of a clock signal and a data signal may be used as digital control signals.

The second controller 62 processes digital control logic/line (DCL) signals (DCL1 and DCL2) received from the RFIC 5 via the control terminals 163 and 164 and thereby generates a control signal for controlling the supply modulator 30. The DCL signals (DCL1 and DCL2) are generated by the RFIC 5 based on an envelope signal of a radio frequency signal. Turning ON/OFF of the switches S51 to S53 included in the supply modulator 30 is controlled by the control signal from the second controller 62.

The DCL signals (DCL1 and DCL2) are each a 1-bit signal. The voltages V1 to V3 are each represented by a combination of two 1-bit signals. For example, V1, V2, and V3 are represented by "00"**,** "01", and "10", respectively. A gray code may be used to express a voltage level.

In this embodiment, two digital control logic/line signals are used to control the supply modulator 30, but the number of digital control logic/line signals is not limited thereto. For example, any number of digital control logic/line signals may be used as long as the number is one, three, or more, in accordance with the number of voltage levels selectable by the respective switches of the supply modulator 30. The digital control signal used to control the supply modulator 30 is not limited to a digital control logic/line signal.

### [1.3 Circuit Configuration of Pre-Regulator Circuit 10]

The circuit configuration of the pre-regulator circuit 10 will then be described with reference to Fig. 3. The pre-regulator circuit 10 includes an input terminal 110, output terminals 111 and 112, switches S71 to S75, a power inductor L71, and capacitors C71 and C72.

The input terminal 110 is a terminal for receiving a power supply voltage from the direct current power source 50. The input terminal 110 is connected to the direct current power source 50 outside the pre-regulator circuit 10 and is connected to the switch S71 inside the pre-regulator circuit 10.

The output terminal 111 is an example of a first output terminal and is a terminal for supplying a first input voltage (V3) to the switched-capacitor circuit 20. The output terminal 111 is connected to the input terminal 121 of the switched-capacitor circuit 20 outside the pre-regulator circuit 10 and is connected to the switch S73 inside the pre-regulator circuit 10.

The output terminal 112 is an example of a second output terminal and is a terminal for supplying a second input voltage (V1) to the switched-capacitor circuit 20. The output terminal 112 is connected to the input terminal 122 of the switched-capacitor circuit 20 outside the pre-regulator circuit 10 and is connected to the switch S74 inside the pre-regulator circuit 10.

The power inductor L71 is an inductor used to raise and lower a direct current voltage. One end of the power inductor L71 is connected to the switches S71 and S72, and the other end of the power inductor L71 is connected to the switches S73 to S75.

The switch S71 is connected between the input terminal 110 and the one end of the power inductor L71. Specifically, the switch S71 includes a terminal connected to the input terminal 110 and a terminal connected to the one end of the power inductor L71. In this connection configuration, ON/OFF switching of the switch S71 enables switching between connection and disconnection between the input terminal 110 and the one end of the power inductor L71.

The switch S72 is connected between the one end of the power inductor L71 and ground. Specifically, the switch S72 includes a terminal connected to the one end of the power inductor L71 and a terminal connected to ground. In this connection configuration, ON/OFF switching of the switch S72 enables switching between connection and disconnection between the one end of the power inductor L71 and ground.

The switch S73 is an example of a first switch and is connected between the other end of the power inductor L71 and the output terminal 111. Specifically, the switch S73 includes a terminal connected to the other end of the power inductor L71 and a terminal connected to the output terminal 111. In this connection configuration, ON/OFF switching of the switch S73 enables switching between connection and disconnection between the other end of the power inductor L71 and the output terminal 111.

The switch S74 is an example of a second switch and is connected between the other end of the power inductor L71 and the output terminal 112. Specifically, the switch S74 includes a terminal connected to the other end of the power inductor L71 and a terminal connected to the output terminal 112. In this connection configuration, ON/OFF switching of the switch S74 enables switching between connection and disconnection between the other end of the power inductor L71 and the output terminal 112.

The switches S73 and S74 each have a withstand voltage lower than the withstand voltage of each of the switches S11 to S14 and S21 to S24 included in the switched-capacitor circuit 20. Conversely, the switches S11 to S14 and S21 to S24 included in the switched-capacitor circuit 20 each have a withstand voltage higher than the withstand voltage of each of the switches S73 and S74 included in the pre-regulator circuit 10.

It is possible to compare withstand voltages of two switches with each other based on the number of transistors connected in series thereto. Specifically, the withstand voltage of a switch connected in series to a larger number of transistors is higher than the withstand voltage of a switch connected in series to a smaller number of transistors.

The switch S75 is an example of a third switch and is connected between the other end of the power inductor L71 and ground. Specifically, the switch S75 includes a terminal connected to the other end of the power inductor L71 and a terminal connected to ground. In this connection configuration, ON/OFF switching of the switch S75 enables switching between connection and disconnection between the other end of the power inductor L71 and ground.

The capacitor C71 is an example of a first capacitor and is connected between ground and a path between the switch S73 and the output terminal 111. Specifically, one of the two electrodes of the capacitor C71 is connected to the switch S73 and the output terminal 111, and the other of the two electrodes of the capacitor C71 is connected to ground.

The capacitor C72 is an example of a second capacitor and is connected between ground and a path between the switch S74 and the output terminal 112. Specifically, one of the two electrodes of the capacitor C72 is connected to the switch S74 and the output terminal 112, and the other of the two electrodes of the capacitor C72 is connected to ground.

The pre-regulator circuit 10 having the above-described configuration is capable of converting a power supply voltage into two variable voltages independent of each other (the first input voltage and the second input voltage of the switched-capacitor circuit 20).

The configuration of the pre-regulator circuit 10 illustrated in Fig. 3 is illustrative and is not restrictive. For example, one or some of the switches S71 to S75 may be replaced with a diode. Part or the entirety of the pre-regulator circuit 10 may be included in the tracker circuit 1.

### [1.4 Tracking Method]

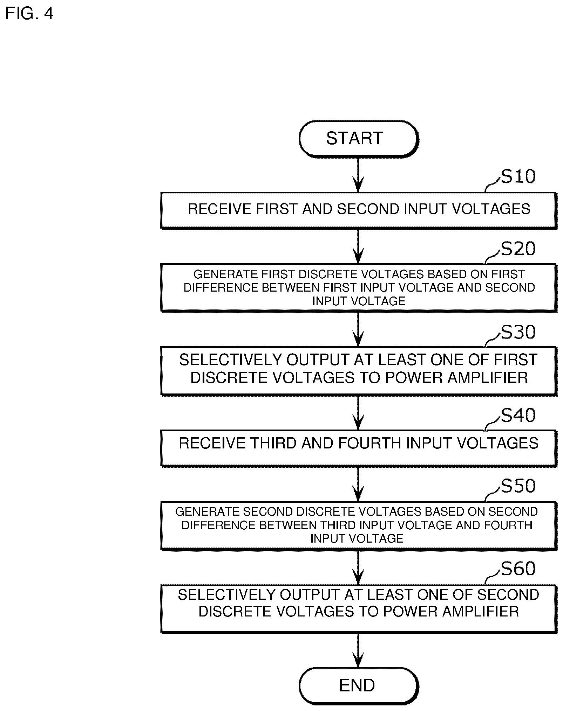

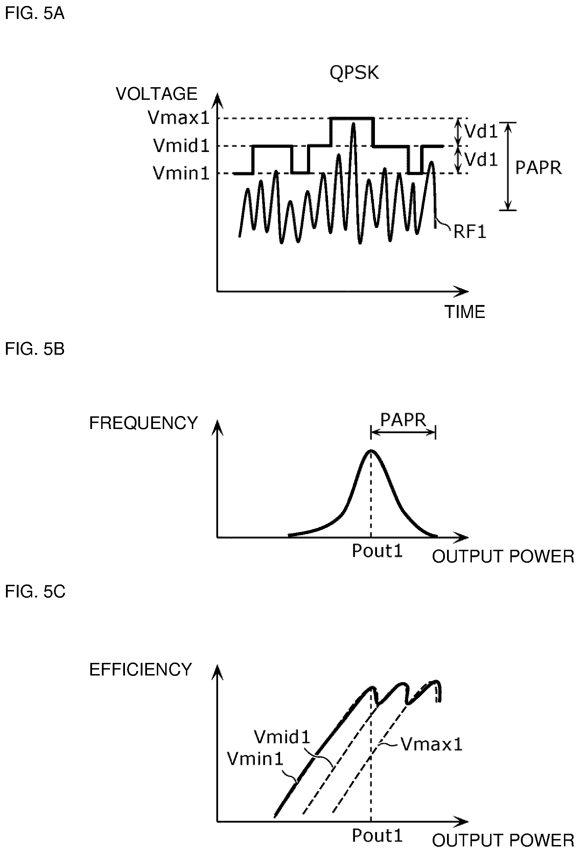

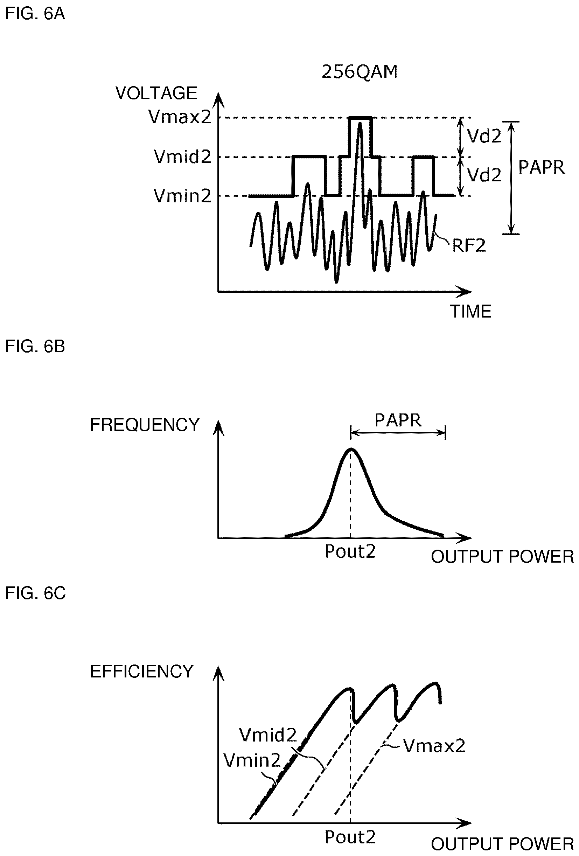

A tracking method that is a method for supplying a plurality of discrete voltages by the tracker circuit 1 having the above-described configuration will then be described with reference to Fig. 4, Fig. 5A to Fig. 5C, and Fig. 6A to Fig. 6C. Fig. 4 is a flowchart illustrating the tracking method according to this embodiment. Fig. 5A is a graph illustrating a radio frequency signal RF1 modulated by QPSK and a plurality of discrete voltages. Fig. 5B is a graph illustrating a relationship between the output power of the power amplifier that amplifies the radio frequency signal RF1 modulated by QPSK and an occurrence frequency. Fig. 5C is a graph illustrating a relationship between the output power of the power amplifier 2 that amplifies the radio frequency signal RF1 modulated by QPSK and power efficiency. Fig. 6A is a graph illustrating a radio frequency signal RF2 modulated by 256QAM and a plurality of discrete voltages. Fig. 6B is a graph illustrating a relationship between the output power of the power amplifier 2 that amplifies the radio frequency signal RF2 modulated by 256QAM and an occurrence frequency. Fig. 6C is a graph illustrating a relationship between the output power of the power amplifier 2 that amplifies the radio frequency signal RF2 modulated by 256QAM and power efficiency.

### <Step S10>

The switched-capacitor circuit 20 receives a first input voltage and a second input voltage from the pre-regulator circuit 10. For example, in a case where a radio frequency signal RF1 modulated by discrete Fourier transform spreading-orthogonal frequency division multiplexing quadrature phase shift keying (DFTs-OFDM QPSK, hereinafter simply referred to as QPSK) is amplified by the power amplifier 2, the switched-capacitor circuit 20 receives a first input voltage (Vmax1) and a second input voltage (Vmin1) from the pre-regulator circuit 10. QPSK is an example of a modulation scheme having a lower bit rate.

### <Step S20>

The switched-capacitor circuit 20 generates a plurality of first discrete voltages based on a first difference between the first input voltage and the second input voltage. Specifically, the switched-capacitor circuit 20 generates a first output voltage based on the first input voltage, a second output voltage based on the second input voltage, and a third output voltage based on the difference between the first input voltage and the second input voltage. For example, in a case where the radio frequency signal RF1 modulated by QPSK is amplified by the power amplifier 2, the switched-capacitor circuit 20 generates, as a plurality of first discrete voltages, a first output voltage (Vmax1) equal to the first input voltage, a second output voltage (Vmin1) equal to the second input voltage, and a third output voltage (Vmid1 = Vmax1 - Vd1 = Vmin1 + Vd1) that is lower than the first input voltage by a half (Vd1) of the first difference and higher than the second input voltage by a half (Vd1) of the first difference, based on the first difference (2Vd1) between the first input voltage (Vmax1) and the second input voltage (Vmin1).

### <Step S30>

The supply modulator 30 selectively outputs at least one of the plurality of first discrete voltages to the power amplifier 2. For example, in a case where the radio frequency signal RF1 modulated by QPSK is amplified by the power amplifier 2, the supply modulator 30 selectively outputs the first output voltage (Vmax1), the second output voltage (Vmin1), and the third output voltage (Vmid1) to the power amplifier 2, based on an envelope signal. As illustrated in Fig. 5A, a voltage based on the envelope of the radio frequency signal RF1 is thereby supplied to the power amplifier 2.

Steps S10 to S30 as described above enables the first output voltage (Vmax1) corresponding to the maximum output power of the radio frequency signal RF1 to be output and the second output voltage (Vmin1) corresponding to output power Pout1 with the highest occurrence frequency of the radio frequency signal RF1 to be output, as illustrated in Fig. 5B and Fig. 5C. This enables the maximum output power of the radio frequency signal RF1 to be supported and the power efficiency for the output power with the highest occurrence frequency of the radio frequency signal RF1 to be improved. Furthermore, the third output voltage (Vmid1) as a middle between the first output voltage (Vmax1) and the second output voltage (Vmin1) may also be output, and thus the power efficiency for the output power between the maximum output power and an average output voltage may also be improved.

### <Step S40>

The switched-capacitor circuit 20 receives a third input voltage and a fourth input voltage from the pre-regulator circuit 10. A second difference between the third input voltage and the fourth input voltage is different from the first difference between the first input voltage and the second input voltage. For example, in a case where a radio frequency signal RF2 modulated by cyclic prefix-orthogonal frequency division multiplexing 256 quadrature amplitude modulation (CP-OFDM 256QAM, hereinafter simply referred to as 256QAM) is amplified by the power amplifier 2, the switched-capacitor circuit 20 receives a third input voltage (Vmax2) and a fourth input voltage (Vmin2) from the pre-regulator circuit 10. At this time, the bit rate of 256QAM is higher than the bit rate of QPSK, and thus the second difference (2Vd2) is larger than the first difference (2Vd1).

256QAM is an example of a modulation scheme having a higher bit rate. In general, QAM (such as 256QAM, 64QAM, or 16QAM) has a higher bit rate and a higher peak to average power ratio (PAPR) than PSK (such as QPSK or binary phase-shift keying (BPSK)).

### <Step S50>

The switched-capacitor circuit 20 generates a plurality of second discrete voltages based on the second difference between the third input voltage and the fourth input voltage. The second difference between the third input voltage and the fourth input voltage is different from the first difference between the first input voltage and the second input voltage, and thus the plurality of second discrete voltages are different from the plurality of first discrete voltages. For example, in a case where the radio frequency signal RF2 modulated by 256QAM is amplified by the power amplifier 2, the switched-capacitor circuit 20 generates, as the plurality of second discrete voltages, a fourth output voltage (Vmax2) equal to the third input voltage, a fifth output voltage (Vmin2) equal to the fourth input voltage, and a sixth output voltage (Vmid2 = Vmax2 - Vd2 = Vmin2 + Vd2) that is lower than the third input voltage by a half (Vd2) of the second difference and higher than the fourth input voltage by a half (Vd2) of the second difference, based on the second difference (2Vd2) between the third input voltage (Vmax2) and the fourth input voltage (Vmin2).

### <Step S60>

The supply modulator 30 selectively outputs at least one of the plurality of second discrete voltages to the power amplifier 2. For example, in a case where the radio frequency signal RF2 modulated by 256QAM is amplified by the power amplifier 2, the supply modulator 30 selectively outputs the fourth output voltage (Vmax2), the fifth output voltage (Vmin2), and the sixth output voltage (Vmid2) to the power amplifier 2, based on an envelope signal. As illustrated in Fig. 6A, a voltage based on the envelope of the radio frequency signal RF2 is thereby supplied to the power amplifier 2.

Steps S40 to S60 as described above enables the fourth output voltage (Vmax2) corresponding to the maximum output power of the radio frequency signal RF2 to be output and the fifth output voltage (Vmin2) corresponding to output power Pout2 with the highest occurrence frequency of the radio frequency signal RF2 to be output, as illustrated in Fig. 6B and Fig. 6C. This enables the maximum output power of the radio frequency signal RF2 to be supported and the power efficiency for the output power with the highest occurrence frequency of the radio frequency signal RF2 to be improved. Furthermore, the sixth output voltage (Vmid2) as a middle between the fourth output voltage (Vmax2) and the fifth output voltage (Vmin2) may also be output, and thus the power efficiency for the output power between the maximum output power and an average output voltage may also be improved.

As described above, different input voltages are used for radio frequency signals that vary in characteristics (in particular, PAPR), and thereby varying the modulation scheme enables generation of an output voltage corresponding to the output power with the highest occurrence frequency (the second output voltage and the fifth output voltage) and an output voltage corresponding to the maximum output power (the first output voltage and the fourth output voltage). As the result, even if the number of the plurality of discrete voltages generated by the switched-capacitor circuit 20 is reduced, a decrease in the power efficiency of the power amplifier 2 may be prevented, and the configuration of the switched-capacitor circuit 20 may be simplified.

### [1.5 Advantageous Effects and the Like]

As described above, the tracker circuit 1 according to this embodiment includes the switched-capacitor circuit 20 configured to generate a plurality of discrete voltages and the supply modulator 30 configured to selectively output at least one of the plurality of discrete voltages to the power amplifier 2. The switched-capacitor circuit 20 is configured to generate the plurality of discrete voltages based on a difference between a first input voltage and a second input voltage, the second input voltage being variable and lower than the first input voltage.

The switched-capacitor circuit thereby generates the plurality of discrete voltages based on the difference between the first input voltage and the second input voltage. Accordingly, the plurality of discrete voltages may be set more flexibly than in a case where the plurality of discrete voltages are generated based on one input voltage, and the power efficiency of the power amplifier 2 may be improved. Furthermore, even if the number of the plurality of discrete voltages generated by the switched-capacitor circuit 20 (i.e., the number of levels) is reduced, a decrease in the power efficiency of the power amplifier 2 may be prevented by changing the second input voltage. Accordingly, the configuration of the switched-capacitor circuit 20 may be simplified, and the power efficiency of the tracker circuit 1 may be improved.

For example, in the tracker circuit 1 according to this embodiment, the first input voltage may be variable.

Accordingly, since both the first input voltage and the second input voltage are variable, the plurality of discrete voltages may be set more flexibly. Accordingly, the power efficiency of the power amplifier 2 may be further improved, and the configuration of the switched-capacitor circuit 20 may be further simplified.

For example, in the tracker circuit 1 according to this embodiment, the plurality of discrete voltages may include a first output voltage based on the first input voltage, a second output voltage based on the second input voltage, and a third output voltage based on the difference between the first input voltage and the second input voltage.

Accordingly, it suffices that only the third output voltage among the first output voltage, the second output voltage, and the third output voltage be generated based on the difference between the first input voltage and the second input voltage. Power consumption for generating the first output voltage and the second output voltage may be reduced, and the plurality of discrete voltages may be generated more stably.

For example, in the tracker circuit 1 according to this embodiment, the third output voltage may be lower than the first output voltage.

Accordingly, the power efficiency of the switched-capacitor circuit 20 may be increased, and the plurality of discrete voltages may be generated more stably.

For example, in the tracker circuit 1 according to this embodiment, the switched-capacitor circuit 20 may be configured to generate the third output voltage to cause each of a difference between the first output voltage and the third output voltage and a difference between the second output voltage and the third output voltage to increase in response to an increase in the difference between the first input voltage and the second input voltage.

The step widths of the plurality of discrete voltages may thereby be controlled by the difference between the first input voltage and the second input voltage. Accordingly, a plurality of discrete voltages suitable for the characteristics (such as PAPR) of a radio frequency signal may be generated, and power efficiency may be improved.

For example, in the tracker circuit 1 according to this embodiment, the difference between the first input voltage and the second input voltage may be switched in accordance with a modulation scheme for a radio frequency signal amplified by the power amplifier 2.

In a case where the characteristics (such as PAPR) of the radio frequency signal change according to a modulation scheme, this enables the step widths of the plurality of discrete voltages to be changed and power efficiency to be improved.

For example, in the tracker circuit 1 according to this embodiment, the difference between the first input voltage and the second input voltage may increase as a bit rate of the modulation scheme for the radio frequency signal increases.

Accordingly, the step widths of the plurality of discrete voltages may be widened as the bit rate of the modulation scheme increases, and it is possible to cope with the PAPR which increases with an increase in the bit rate and to improve power efficiency.

For example, in the tracker circuit 1 according to this embodiment, the difference between the first input voltage and the second input voltage may be switched at the time of switching of a frame of the radio frequency signal amplified by the power amplifier 2.

Accordingly, it is possible to prevent radio frequency signal deterioration due to instability of the plurality of discrete voltages at the time of switching of the difference between the first input voltage and the second input voltage.

For example, the tracker circuit 1 according to this embodiment may be connected to the pre-regulator circuit 10 configured to convert a power supply voltage into the first input voltage and the second input voltage.

Accordingly, since the tracker circuit 1 is connected to the pre-regulator circuit 10 having one input and two outputs, the number of pre-regulator circuits 10 may be reduced.

The communication device 7 according to this embodiment includes the tracker circuit 1, the pre-regulator circuit 10 configured to convert a power supply voltage into the first input voltage and the second input voltage, the RFIC 5 configured to process a radio frequency signal, and the radio frequency circuit 4 including the power amplifier 2 and configured to transmit the radio frequency signal between the RFIC 5 and the antenna 6.

Advantageous effects similar to those of the tracker circuit 1 may thereby be achieved. As the result, the power consumption of the communication device 7 may be reduced, and the battery life of the communication device 7 may be extended.

A tracking method according to this embodiment includes receiving a first input voltage and a second input voltage lower than the first input voltage (S10); generating a plurality of first discrete voltages based on a first difference between the first input voltage and the second input voltage (S20); selectively outputting at least one of the plurality of first discrete voltages to the power amplifier 2 (S30); receiving a third input voltage and a fourth input voltage that is lower than the third input voltage (S40), the fourth input voltage being different from the second input voltage; generating a plurality of second discrete voltages based on a second difference between the third input voltage and the fourth input voltage (S50); and selectively outputting at least one of the plurality of second discrete voltages to the power amplifier 2 (S60).

This causes the plurality of first discrete voltages to be generated based on the first difference between the first input voltage and the second input voltage and the plurality of second discrete voltages to be generated based on the second difference between the third input voltage and the fourth input voltage. Accordingly, changing two input voltages enables the plurality of discrete voltages to be set more flexibly than in the case where the plurality of discrete voltages are generated based on one input voltage and enables the power efficiency of the power amplifier 2 to be improved. Furthermore, even if the number of the plurality of discrete voltages is reduced, a decrease in the power efficiency of the power amplifier 2 may be prevented by changing the second input voltage. Accordingly, the configuration of the tracker circuit 1 may be simplified, and the power efficiency of the tracker circuit 1 may be improved.

### (Modification of Embodiment 1)

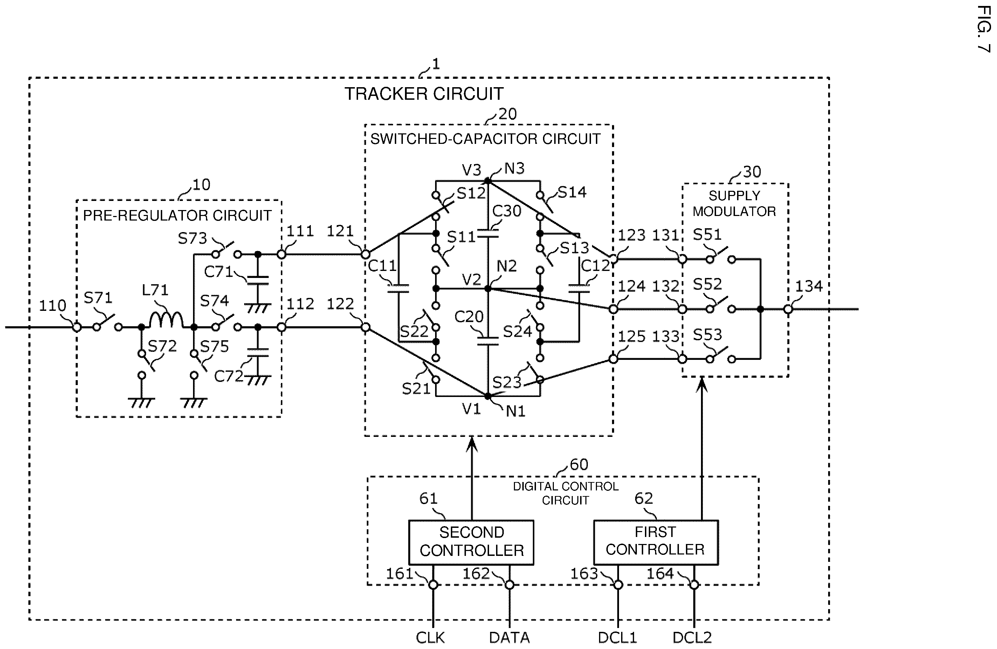

A modification of Embodiment 1 will then be described. As described for Embodiment 1 above, the tracker circuit 1 may include part or the entirety of the pre-regulator circuit 10. Hence, a tracker circuit 1 according to this modification includes the entire pre-regulator circuit 10, as illustrated in Fig. **7****.** The tracker circuit 1 may include only part of the pre-regulator circuit 10, for example, only the capacitors C71 and C72.

As described above, the tracker circuit 1 according to this modification includes the switched-capacitor circuit 20 including the input terminal 121 and the input terminal 122, the supply modulator 30, the capacitor C71, and the capacitor C71. The switched-capacitor circuit 20 is configured to generate the plurality of discrete voltages. The input terminal 121 receives the first input voltage, and the input terminal 122 receives the second input voltage that is variable and that is lower than the first input voltage. The supply modulator 30 is configured to selectively output at least one of the plurality of discrete voltages to the power amplifier 2. The capacitor C71 is connected between the input terminal 121 and ground, and the capacitor C72 is connected between the input terminal 122 and ground.

The first input voltage and the second input voltage may thereby be received via the input terminals 121 and 122 which are connected in shunt to the two different capacitors C71 and C72, and thus the switched-capacitor circuit 20 may receive the first input voltage and the second input voltage independent of each other. Accordingly, the plurality of discrete voltages may be set more flexibly than in the case where the plurality of discrete voltages are generated based on one input voltage, and the power efficiency of the power amplifier 2 may be improved. Furthermore, even if the number of plurality of discrete voltages generated by the switched-capacitor circuit 20 (i.e., the number of levels) is reduced, a decrease in the power efficiency of the power amplifier 2 may be prevented. Accordingly, the configuration of the switched-capacitor circuit 20 may be simplified, and the power efficiency of the tracker circuit 1 may also be improved.

For example, the tracker circuit 1 according to this modification may further include the pre-regulator circuit 10. The pre-regulator circuit 10 may include the power inductor L71, the output terminal 111 connected to the input terminal 121 of the switched-capacitor circuit 20, the output terminal 112 connected to the input terminal 122 of the switched-capacitor circuit 20, the switch S73 connected between an output end of the power inductor L71 and the output terminal 111, the switch S74 connected between the output end of the power inductor L71 and the output terminal 112, the switch S75 connected between the output end of the power inductor L71 and ground, and the capacitor C71 and the capacitor C72. The capacitor C71 may be connected between ground and a path between the switch S73 and the output terminal 111. The capacitor C72 may be connected between ground and a path between the switch S74 and the output terminal 112.

Since the tracker circuit 1 thereby includes the one-input two-output pre-regulator circuit 10, it is not necessary to provide a pre-regulator circuit 10 separately, and the tracker circuit 1 may be easily introduced into the communication device 7.

For example, in the tracker circuit 1 according to this modification, the withstand voltage of a switch included in the switched-capacitor circuit 20 may be higher than the withstand voltage of each of the switches S73 and S74 included in the pre-regulator circuit 10.

This enables the withstand voltage of the switch included in the switched-capacitor circuit 20 to be made relatively high, breakdown of the switched-capacitor circuit 20 to be prevented in a case where the difference between the first input voltage and the second input voltage is large, and the plurality of discrete voltages to be set more flexibly.

### (Embodiment 2)

Embodiment 2 will then be described. This embodiment is different from Embodiment 1 described above mainly in that a switched-capacitor circuit receives two input voltages from two pre-regulator circuits, respectively. Hereinafter, this embodiment will be described with reference to the drawings, with a focus on the difference from Embodiment 1 described above.

### [2.1 Circuit Configuration of Communication Device 7A]

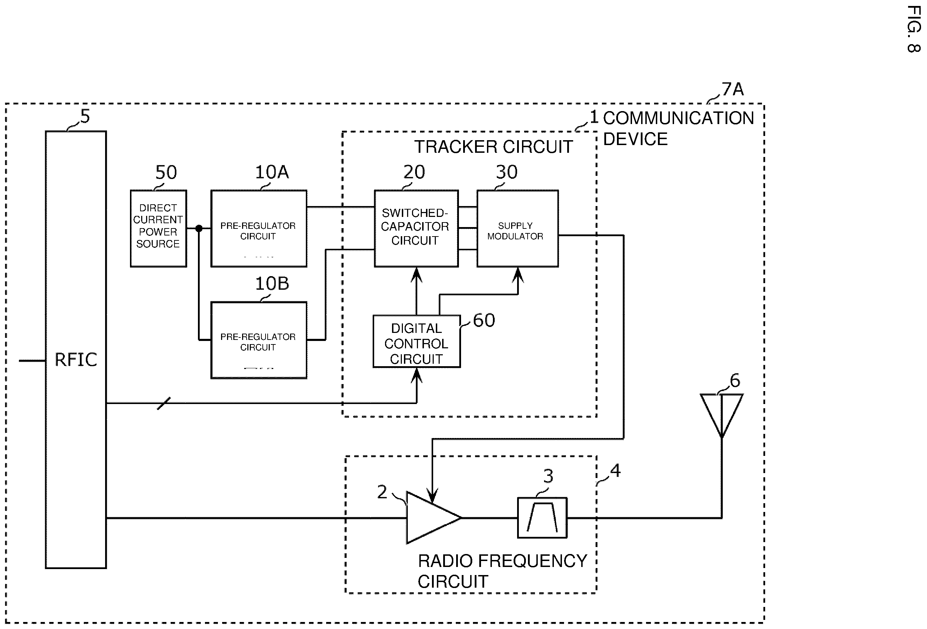

A communication device 7A according to this embodiment will be described with reference to Fig. 8. Fig. 8 is a circuit configuration diagram of the communication device 7A according to this embodiment.

Fig. 8 illustrates an exemplary circuit configuration, and the communication device 7A may be implemented by using any of a wide variety of circuit implementation and circuit techniques. Accordingly, the description of the communication device 7A provided below should not be construed in a limiting manner.

The communication device 7A according to this embodiment includes the tracker circuit 1, the radio frequency circuit 4, the RFIC 5, the antenna 6, pre-regulator circuits 10A and 10B, and the direct current power source 50.

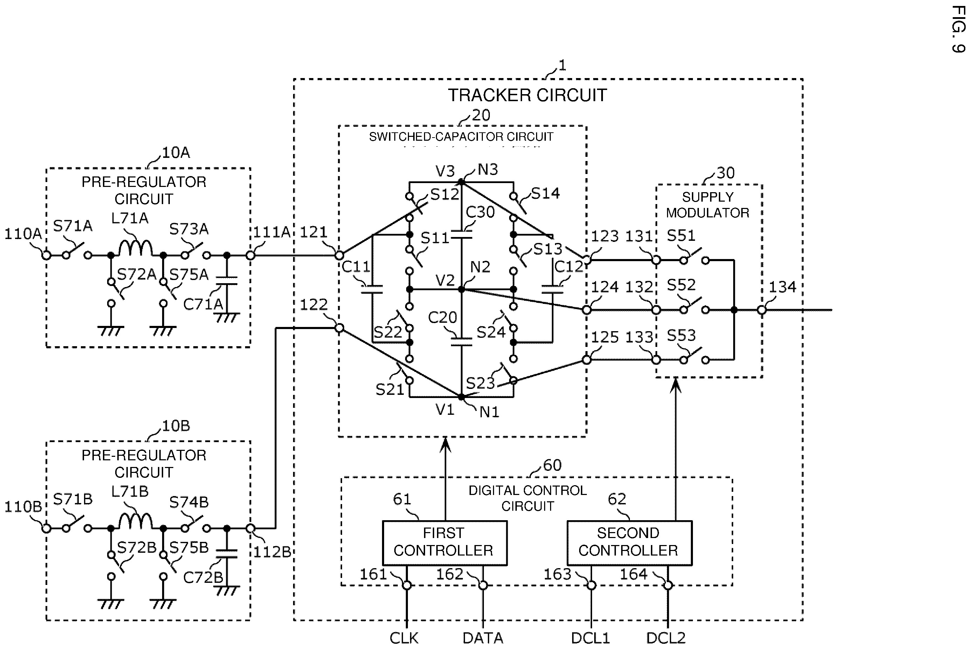

The pre-regulator circuit 10A is an example of a first converter circuit and is a one-input one-output buck-boost converter. The pre-regulator circuit 10A is capable of converting a power supply voltage supplied from the direct current power source 50 into one variable voltage (the first input voltage of the switched-capacitor circuit 20). The pre-regulator circuit 10A is capable of changing the first input voltage based on, for example, a control signal from the RFIC 5. The circuit configuration of the pre-regulator circuit 10A will be described later by using Fig. 9.

The pre-regulator circuit 10B is an example of a second converter circuit and is a one-input one-output buck-boost converter. The pre-regulator circuit 10B is capable of converting a power supply voltage supplied from the direct current power source 50 into one variable voltage (the second input voltage of the switched-capacitor circuit 20). The pre-regulator circuit 10B is capable of changing the second input voltage based on, for example, a control signal from the RFIC 5. The circuit configuration of the pre-regulator circuit 10B will be described later by using Fig. 9.

The pre-regulator circuits 10A and 10B are capable of switching the difference between the first input voltage and the second input voltage in accordance with, for example, a modulation scheme for a radio frequency signal amplified by the power amplifier 2. More specifically, the pre-regulator circuits 10A and 10B may increase the difference between the first input voltage and the second input voltage as the bit rate of the modulation scheme increases. Such switching of the difference between the first input voltage and the second input voltage may be performed at the time of switching of a frame of the radio frequency signal.

### [2.2 Circuit Configuration of Pre-Regulator Circuit 10A]

The circuit configuration of the pre-regulator circuit 10A will be described with reference to Fig. 9. Fig. 9 is a circuit configuration diagram of the tracker circuit 1 and the pre-regulator circuits 10A and 10B according to this embodiment.

Fig. 9 illustrates an exemplary circuit configuration, and the tracker circuit 1 and the pre-regulator circuits 10A and 10B may be implemented by using any of a wide variety of circuit implementation and circuit techniques. Accordingly, the description of the individual circuits provided below should not be construed in a limiting manner.

The pre-regulator circuit 10A includes an input terminal 110A, an output terminal 111A, switches S71A to S73A and S75A, a power inductor L71A, and a capacitor C71A.

The input terminal 110A is a terminal for receiving a power supply voltage from the direct current power source 50. The input terminal 110A is connected to the direct current power source 50 outside the pre-regulator circuit 10A and is connected to the switch S71A inside the pre-regulator circuit 10A.

The output terminal 111A is a terminal for supplying a first input voltage (V3) to the switched-capacitor circuit 20. The output terminal 111A is connected to the input terminal 121 of the switched-capacitor circuit 20 outside the pre-regulator circuit 10A and is connected to the switch S73A inside the pre-regulator circuit 10A.

The power inductor L71A is an inductor used to raise and lower a direct current voltage. One end of the power inductor L71A is connected to the switches S71A and S72A, and the other end of the power inductor L71A is connected to the switches S73A and S75A.

The switch S71A is connected between the input terminal 110A and the one end of the power inductor L71A. Specifically, the switch S71A includes a terminal connected to the input terminal 110A and a terminal connected to the one end of the power inductor L71A. In this connection configuration, ON/OFF switching of the switch S71A enables switching between connection and disconnection between the input terminal 110A and the one end of the power inductor L71A.

The switch S72A is connected between the one end of the power inductor L71A and ground. Specifically, the switch S72A includes a terminal connected to the one end of the power inductor L71A and a terminal connected to ground. In this connection configuration, ON/OFF switching of the switch S72A enables switching between connection and disconnection between the one end of the power inductor L71A and ground.

The switch S73A is connected between the other end of the power inductor L71A and the output terminal 111A. Specifically, the switch S73A includes a terminal connected to the other end of the power inductor L71A and a terminal connected to the output terminal 111A. In this connection configuration, ON/OFF switching of the switch S73A enables switching between connection and disconnection between the other end of the power inductor L71A and the output terminal 111A.

The switch S75A is connected between the other end of the power inductor L71A and ground. Specifically, the switch S75A includes a terminal connected to the other end of the power inductor L71A and a terminal connected to ground. In this connection configuration, ON/OFF switching of the switch S75A enables switching between connection and disconnection between the other end of the power inductor L71A and ground.

The capacitor C71A is connected between ground and a path between the switch S73A and the output terminal 111A. Specifically, one of the two electrodes of the capacitor C71A is connected to the switch S73A and the output terminal 111A, and the other of the two electrodes of the capacitor C71A is connected to ground.

The pre-regulator circuit 10A having the above-described configuration is capable of converting a power supply voltage into a variable voltage V3 (the first input voltage of the switched-capacitor circuit 20).

The configuration of the pre-regulator circuit 10A illustrated in Fig. 9 is illustrative and is not restrictive. For example, one or some of the switches S71A to S73A and S75A may be replaced with a diode. Part or the entirety of the pre-regulator circuit 10A may be included in the tracker circuit 1, like the pre-regulator circuit 10 according to the modification of Embodiment 1.

### [2.3 Circuit Configuration of Pre-Regulator Circuit 10B]

The circuit configuration of the pre-regulator circuit 10B will be described with reference to Fig. 9. The pre-regulator circuit 10B includes an input terminal 110B, an output terminal 112B, switches S71B, S72B, S74B, and S75B, a power inductor L71B, and a capacitor C72B.

The input terminal 110B is a terminal for receiving a power supply voltage from the direct current power source 50. The input terminal 110B is connected to the direct current power source 50 outside the pre-regulator circuit 10B and is connected to the switch S71B inside the pre-regulator circuit 10B.

The output terminal 112B is a terminal for supplying a second input voltage (V1) to the switched-capacitor circuit 20. The output terminal 112B is connected to the input terminal 122 of the switched-capacitor circuit 20 outside the pre-regulator circuit 10B and is connected to the switch S74B inside the pre-regulator circuit 10B.

The power inductor L71B is an inductor used to raise and lower a direct current voltage. One end of the power inductor L71B is connected to the switches S71B and S72B, and the other end of the power inductor L71B is connected to the switches S74B and S75B.

The switch S71B is connected between the input terminal 110B and the one end of the power inductor L71B. Specifically, the switch S71B includes a terminal connected to the input terminal 110B and a terminal connected to the one end of the power inductor L71B. In this connection configuration, ON/OFF switching of the switch S71B enables switching between connection and disconnection between the input terminal 110B and the one end of the power inductor L71B.

The switch S72B is connected between the one end of the power inductor L71B and ground. Specifically, the switch S72B includes a terminal connected to the one end of the power inductor L71B and a terminal connected to ground. In this connection configuration, ON/OFF switching of the switch S72B enables switching between connection and disconnection between the one end of the power inductor L71B and ground.

The switch S74B is connected between the other end of the power inductor L71B and the output terminal 112B. Specifically, the switch S74B includes a terminal connected to the other end of the power inductor L71B and a terminal connected to the output terminal 112B. In this connection configuration, ON/OFF switching of the switch S74B enables switching between connection and disconnection between the other end of the power inductor L71B and the output terminal 112B.

The switch S75B is connected between the other end of the power inductor L71B and ground. Specifically, the switch S75B includes a terminal connected to the other end of the power inductor L71B and a terminal connected to ground. In this connection configuration, ON/OFF switching of the switch S75B enables switching between connection and disconnection between the other end of the power inductor L71B and ground.

The capacitor C72B is connected between ground and a path between the switch S74B and the output terminal 112B. Specifically, one of the two electrodes of the capacitor C72B is connected to the switch S74B and the output terminal 112B, and the other of the two electrodes of the capacitor C72B is connected to ground.

The pre-regulator circuit 10B having the above-described configuration is capable of converting a power supply voltage into a variable voltage V1 (the second input voltage of the switched-capacitor circuit 20).

The configuration of the pre-regulator circuit 10B illustrated in Fig. 9 is illustrative and is not restrictive. For example, one or some of the switches S71B, S72B, S74B, and S75B may be replaced with a diode. Part or the entirety of the pre-regulator circuit 10B may be included in the tracker circuit 1, like the pre-regulator circuit 10 according to the modification of Embodiment 1.

### [2.4 Advantageous Effects and the Like]

As described above, the tracker circuit 1 according to this embodiment is connected to the pre-regulator circuit 10A and the pre-regulator circuit 10B, the pre-regulator circuit 10A being configured to convert a power supply voltage into the first input voltage, the pre-regulator circuit 10B being configured to convert the power supply voltage into the second input voltage.

Accordingly, one-input one-output buck-boost converters, which are often used in communication devices in the related art, may be used, and the tracker circuit 1 may be easily introduced into the communication device 7A.

### (Embodiment 3)

Embodiment 3 will then be described. This embodiment is different from Embodiments 1 and 2 described above mainly in that a voltage supplied from a pre-regulator circuit is lowered in a tracker circuit to thereby generate two input voltages of a switched-capacitor circuit. Hereinafter, this embodiment will be described with reference to the drawings, with a focus on the difference from Embodiments 1 and 2 described above.

### [3.1 Circuit Configuration of Communication Device 7B]

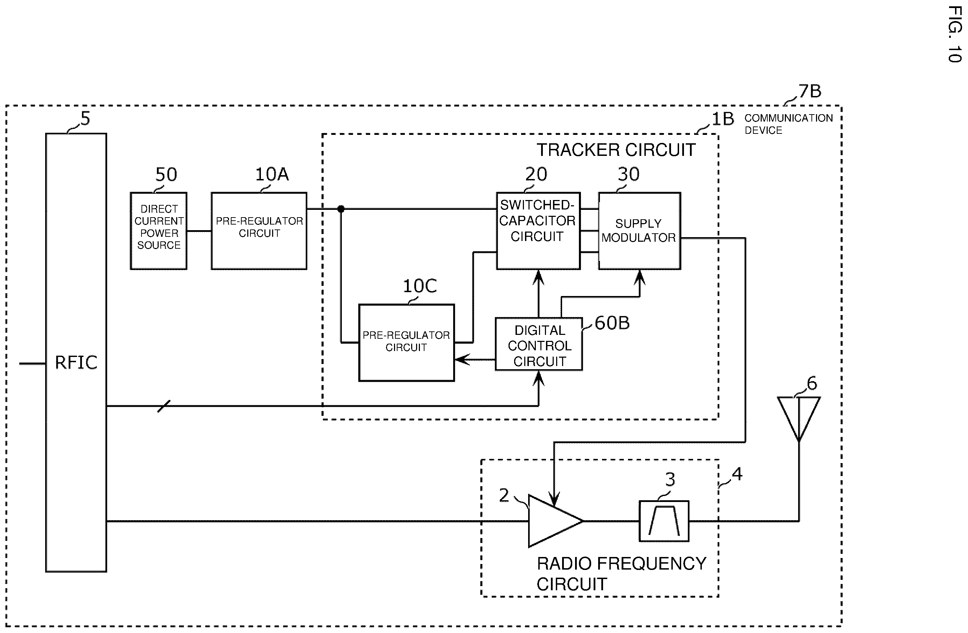

A communication device 7B according to this embodiment will be described with reference to Fig. 10. Fig. 10 is a circuit configuration diagram of the communication device 7B according to this embodiment.

Fig. 10 illustrates an exemplary circuit configuration, and the communication device 7B may be implemented by using any of a wide variety of circuit implementation and circuit techniques. Accordingly, the description of the communication device 7B provided below should not be construed in a limiting manner.

The communication device 7B according to this embodiment includes a tracker circuit 1B, the radio frequency circuit 4, the RFIC 5, the antenna 6, the pre-regulator circuit 10A, and the direct current power source 50.

The tracker circuit 1B is capable of supplying a plurality of discrete voltages to the power amplifier 2 in the digital ET mode. As illustrated in Fig. 10, the tracker circuit 1B includes a pre-regulator circuit 10C, the switched-capacitor circuit 20, the supply modulator 30, and a digital control circuit 60B.

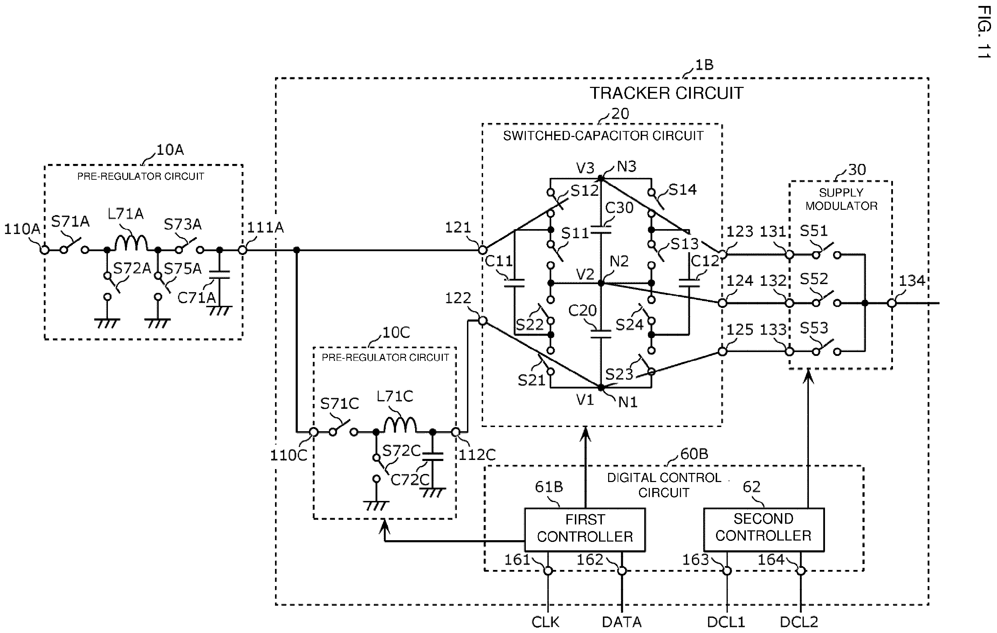

The pre-regulator circuit 10C is an example of a converter circuit and is a buck converter. The pre-regulator circuit 10C is capable of lowering a first input voltage supplied from the pre-regulator circuit 10A to a variable second input voltage. The pre-regulator circuit 10C is capable of changing the second input voltage based on a control signal from the digital control circuit 60. The circuit configuration of the pre-regulator circuit 10C will be described later by using Fig. 11.

The pre-regulator circuits 10A and 10C are capable of switching the difference between the first input voltage and the second input voltage in accordance with, for example, a modulation scheme for a radio frequency signal amplified by the power amplifier 2. More specifically, the pre-regulator circuits 10A and 10C may increase the difference between the first input voltage and the second input voltage as the bit rate of the modulation scheme increases. Such switching of the difference between the first input voltage and the second input voltage may be performed at the time of switching of a frame of the radio frequency signal. The pre-regulator circuit 10A may be included in the tracker circuit 1B, like the pre-regulator circuit 10 according to the modification of Embodiment 1.

The digital control circuit 60B is capable of controlling the pre-regulator circuit 10C in addition to the switched-capacitor circuit 20 and the supply modulator 30 based on digital control signals from the RFIC 5. Specifically, the digital control circuit 60B is further capable of generating and outputting a control signal for controlling a switch included in the pre-regulator circuit 10C. The circuit configuration of the digital control circuit 60B will be described later by using Fig. 11. The digital control circuit 60B does not necessarily have to be included in the tracker circuit 1B.

### [3.2 Circuit Configuration of Tracker Circuit 1B]

The circuit configuration of the tracker circuit 1B will be described with reference to Fig. 11. Fig. 11 is a circuit configuration diagram of the tracker circuit 1B and the pre-regulator circuit 10A according to this embodiment.

Fig. 11 illustrates an exemplary circuit configuration, and the tracker circuit 1B and the pre-regulator circuit 10A may be implemented by using any of a wide variety of circuit implementation and circuit techniques. Accordingly, the description of the individual circuits provided below should not be construed in a limiting manner.

As described above, the tracker circuit 1B includes the pre-regulator circuit 10C, the switched-capacitor circuit 20, the supply modulator 30, and the digital control circuit 60B. The tracker circuit 1B may include a filter circuit (not illustrated) between the supply modulator 30 and the power amplifier 2.

Hereinafter, the circuit configurations of the pre-regulator circuit 10C and the digital control circuit 60B will be described in order.

### [3.2.1 Circuit Configuration of Pre-Regulator Circuit 10C]

First, the circuit configuration of the pre-regulator circuit 10C will be described with reference to Fig. 11. The pre-regulator circuit 10C includes an input terminal 110C, an output terminal 112C, switches S71C and S72C, a power inductor L71C, and a capacitor C72C.

The input terminal 110C is a terminal for receiving a first input voltage from the pre-regulator circuit 10A. The input terminal 110C is connected to the pre-regulator circuit 10A outside the pre-regulator circuit 10C and is connected to the switch S71C inside the pre-regulator circuit 10C.

The output terminal 112C is a terminal for supplying a second input voltage (V1) to the switched-capacitor circuit 20. The output terminal 112C is connected to the input terminal 122 of the switched-capacitor circuit 20 outside the pre-regulator circuit 10C and is connected to the power inductor L71C inside the pre-regulator circuit 10C.

The power inductor L71C is an inductor used to raise and lower a direct current voltage. One end of the power inductor L71C is connected to the switches S71C and S72C, and the other end of the power inductor L71C is connected to the output terminal 112C.

The switch S71C is connected between the input terminal 110C and the one end of the power inductor L71C. Specifically, the switch S71C includes a terminal connected to the input terminal 110C and a terminal connected to the one end of the power inductor L71C. In this connection configuration, ON/OFF switching of the switch S71C enables switching between connection and disconnection between the input terminal 110C and the one end of the power inductor L71C.

The switch S72C is connected between the one end of the power inductor L71C and ground. Specifically, the switch S72C includes a terminal connected to the one end of the power inductor L71C and a terminal connected to ground. In this connection configuration, ON/OFF switching of the switch S72C enables switching between connection and disconnection between the one end of the power inductor L71C and ground.

The capacitor C72C is connected between ground and a path between the other end of the power inductor L71C and the output terminal 112C. Specifically, one of the two electrodes of the capacitor C72C is connected to the other end of the power inductor L71C and the output terminal 112C, and the other of the two electrodes of the capacitor C72C is connected to ground.

The pre-regulator circuit 10C having the above-described configuration is capable of lowering a variable voltage V3 (the first input voltage of the switched-capacitor circuit 20) to a variable voltage V1 (the second input voltage of the switched-capacitor circuit 20).

The configuration of the pre-regulator circuit 10C illustrated in Fig. 11 is illustrative and is not restrictive. For example, the switch S72C may be replaced with a diode. The pre-regulator circuit 10C may be a boost converter. In this case, the pre-regulator circuit 10C may be configured to receive a second input voltage from the pre-regulator circuit 10A and raise the second input voltage to a first input voltage.

### [3.2.2 Circuit Configuration of Digital Control Circuit 60B]

The circuit configuration of the digital control circuit 60B will then be described with reference to Fig. 11. The digital control circuit 60B includes a first controller 61B, the second controller 62, and the control terminals 161 to 164.

The first controller 61B is capable of processing source-synchronous digital control signals received from the RFIC 5 via the control terminals 161 and 162 and thereby generating control signals for controlling the switched-capacitor circuit 20 and the pre-regulator circuit 10C. Turning ON/OFF of the switches S71C and S72C included in the pre-regulator circuit 10C is controlled by a control signal from the first controller 61B.

The digital control signals processed by the first controller 61B are not limited to source-synchronous digital control signals. For example, the first controller 61B may process clock-embedded digital control signals. The first controller 61B may generate a control signal for controlling the supply modulator 30.

Although one set of a clock signal and a data signal is used in this embodiment, the present invention is not limited thereto. For example, a plurality of sets of a clock signal and a data signal may be used as digital control signals. For example, sets of a clock signal and a data signal may be individually used for the pre-regulator circuit 10C and the switched-capacitor circuit 20.

### [3.3 Advantageous Effects and the Like]

As described above, the tracker circuit 1B according to this embodiment further includes the pre-regulator circuit 10C configured to lower the first input voltage to the second input voltage.

Accordingly, a one-input one-output buck-boost converter, which is often used in communication devices of the related art, may be used, and furthermore, the tracker circuit 1B may be operated by one buck-boost converter. The tracker circuit 1B may thus be introduced into the communication device 7B more easily.

### (Other Embodiments)

The tracker circuit, the communication device, and the tracking method according to the present invention have heretofore been described based on the embodiments; however, the tracker circuit, the communication device, and the tracking method according to the present invention are not limited to the embodiments above. Another embodiment implemented by combining any components in the embodiments above, modifications obtained by applying various changes conceived by those skilled in the art to the embodiments above without departing from the gist of the present invention, and various devices including the above-described tracker circuit are also included in the present invention.

For example, in the circuit configurations of the various circuits according to the embodiments above, another circuit element, wiring line, and the like may be inserted between individual circuit elements and paths connecting signal paths disclosed in the drawings. For example, an inductor and/or a capacitor may be inserted between the tracker circuit 1 and the power amplifier 2.

In the embodiments above, a first input voltage is supplied to the node N3 of the switched-capacitor circuit 20, and a second input voltage is supplied to the node N1; however, the present invention is not limited thereto. For example, the first input voltage may be supplied to the node N2, and the second input voltage may be supplied to the node N1. In this case, a third output voltage based on the difference between the first input voltage and the second input voltage is output from the output terminal 123. Alternatively, the first input voltage may be supplied to the node N3, and the second input voltage may be supplied to the node N2. In this case, a third output voltage based on the difference between the first input voltage and the second input voltage is output from the output terminal 125.

In the embodiments above, the switched-capacitor circuit 20 generates three discrete voltages; however, the number of discrete voltages is not limited to three. For example, the switched-capacitor circuit 20 may generate four or more discrete voltages.

The tracker circuit 1 and/or the tracker circuit 1B according to the embodiments above may include a plurality of supply modulators. In this case, the tracker circuit 1 and/or the tracker circuit 1B may supply different voltages to a plurality of power amplifiers.

### Industrial Applicability

The present invention are widely usable, as a tracker circuit for supplying a voltage to a power amplifier, for communication devices such as mobile phones.

### Reference Signs List

1, 1B tracker circuit
2 power amplifier
3 filter
4 radio frequency circuit
5 RFIC
6 antenna
7, 7A, 7B communication device
10, 10A, 10B, 10C pre-regulator circuit
20 switched-capacitor circuit
30 supply modulator
50 direct current power source
60, 60B digital control circuit
61, 61B first controller
62 second controller
110, 110A, 110B, 110C, 121, 122, 131, 132, 133 input terminal
111, 111A, 112, 112B, 112C, 123, 124, 125, 134 output terminal
161, 162, 163, 164 control terminal

## Claims

1. A tracker circuit comprising:
a switched-capacitor circuit configured to generate a plurality of discrete voltages; and
a supply modulator configured to selectively output at least one of the plurality of discrete voltages to a power amplifier,
wherein the switched-capacitor circuit is configured to generate the plurality of discrete voltages, based on a difference between a first input voltage and a second input voltage that is variable and that is lower than the first input voltage.

2. The tracker circuit according to Claim 1,
wherein the first input voltage is variable.

3. The tracker circuit according to Claim 2,
wherein the plurality of discrete voltages include a first output voltage based on the first input voltage, a second output voltage based on the second input voltage, and a third output voltage based on the difference between the first input voltage and the second input voltage.

4. The tracker circuit according to Claim 3,
wherein the third output voltage is lower than the first output voltage.

5. The tracker circuit according to Claim 3 or 4,
wherein the switched-capacitor circuit generates the third output voltage to cause each of a difference between the first output voltage and the third output voltage and a difference between the second output voltage and the third output voltage to increase in response to an increase in the difference between the first input voltage and the second input voltage.

6. The tracker circuit according to any one of Claims 1 to 5,
wherein the difference between the first input voltage and the second input voltage is switched in accordance with a modulation scheme for a radio frequency signal amplified by the power amplifier.

7. The tracker circuit according to Claim **6,**
wherein the difference between the first input voltage and the second input voltage increases as a bit rate of the modulation scheme for the radio frequency signal increases.

8. The tracker circuit according to Claim 6 or 7,
wherein the difference between the first input voltage and the second input voltage is switched at a time of switching of a frame of the radio frequency signal amplified by the power amplifier.

9. The tracker circuit according to any one of Claims 1 to 8,
wherein the tracker circuit is connected to a converter circuit configured to convert a power supply voltage into the first input voltage and the second input voltage.

10. The tracker circuit according to any one of Claims 1 to 8,
wherein the tracker circuit is connected to a first converter circuit and a second converter circuit, the first converter circuit being configured to convert a power supply voltage into the first input voltage, the second converter circuit being configured to convert the power supply voltage into the second input voltage.

11. The tracker circuit according to any one of Claims 1 to 8, further comprising:
a converter circuit configured to lower the first input voltage to the second input voltage.

12. A communication device comprising:
the tracker circuit according to any one of Claims 1 to 11;
a converter circuit configured to convert a power supply voltage into the first input voltage and the second input voltage;
a signal processing circuit configured to process a radio frequency signal; and
a radio frequency circuit including the power amplifier and configured to transmit the radio frequency signal between the signal processing circuit and an antenna.

13. A tracker circuit comprising:
a switched-capacitor circuit that includes a first input terminal and a second input terminal and that is configured to generate a plurality of discrete voltages, the first input terminal receiving a first input voltage, the second input terminal receiving a second input voltage that is variable and that is lower than the first input voltage;
a supply modulator configured to selectively output at least one of the plurality of discrete voltages to a power amplifier;
a first capacitor connected between the first input terminal and ground; and
a second capacitor connected between the second input terminal and ground.

14. The tracker circuit according to Claim 13, further comprising:
a converter circuit,
wherein the converter circuit includes
a power inductor,
a first output terminal connected to the first input terminal of the switched-capacitor circuit,
a second output terminal connected to the second input terminal of the switched-capacitor circuit,
a first switch connected between an output end of the power inductor and the first output terminal,
a second switch connected between the output end of the power inductor and the second output terminal,
a third switch connected between the output end of the power inductor and ground, and
the first capacitor and the second capacitor,
wherein the first capacitor is connected between ground and a path between the first switch and the first output terminal, and
wherein the second capacitor is connected between ground and a path between the second switch and the second output terminal.

15. The tracker circuit according to Claim 14,
wherein the switched-capacitor circuit includes a switch having a withstand voltage that is higher than a withstand voltage of each of the first switch and the second switch that are included in the converter circuit.

16. The tracker circuit according to any one of Claims 13 to 15,
wherein the plurality of discrete voltages include a first output voltage based on the first input voltage, a second output voltage based on the second input voltage, and a third output voltage based on a difference between the first input voltage and the second input voltage.

17. The tracker circuit according to Claim 16,
wherein the third output voltage is lower than the first output voltage.

18. The tracker circuit according to Claim 16 or 17,
wherein the switched-capacitor circuit is configured to generate the third output voltage to cause each of a difference between the first output voltage and the third output voltage and a difference between the second output voltage and the third output voltage to increase in response to an increase in the difference between the first input voltage and the second input voltage.

19. A communication device comprising:
the tracker circuit according to any one of Claims 13 to 18;
a converter circuit configured to convert a power supply voltage into the first input voltage and the second input voltage;
a signal processing circuit configured to process a radio frequency signal; and
a radio frequency circuit including the power amplifier and configured to transmit the radio frequency signal between the signal processing circuit and an antenna.

20. A tracking method comprising:
receiving a first input voltage and a second input voltage lower than the first input voltage;
based on a first difference between the first input voltage and the second input voltage, generating a plurality of first discrete voltages;
selectively outputting at least one of the plurality of first discrete voltages to a power amplifier;
receiving a third input voltage and a fourth input voltage that is lower than the third input voltage, the fourth input voltage being different from the second input voltage;
based on a second difference between the third input voltage and the fourth input voltage, generating a plurality of second discrete voltages; and
selectively outputting at least one of the plurality of second discrete voltages to the power amplifier.
